# EUROPEAN PATENT APPLICATION

(11) **EP 2 818 365 A1**
(43) Date of publication of application: **31.12.2014**
(21) Application number: 13290149.7
(22) Date of filing: 24.06.2013
(51) Int. Cl.: B60R 16/023, H05K 5/00

(54) **Electric module and motor vehicle with an electric module**

(71) Applicant: Behr France Rouffach SAS, 68250 Rouffach (FR)
(72) Inventor: Gries, Jean-Philippe, 68000 Colmar (FR)
(74) Representative: Grauel, Andreas

(57) **Abstract**

The invention relates to an electric module (10) in particular for a motor vehicle comprising a housing (12) in order to accommodate an electric device (30) and connection means (18, 22, 28) for electrically connecting electric input and/or output and/or signal input and/or output of the electronic device of the electric module (10) to surrounding electric components and to the power network of the motor vehicle, wherein the housing (12) comprises a top wall (14), a bottom wall (32), a first side wall (16), a second side wall (20) opposite to the first side wall (16) and extending from the top wall (14) to the bottom wall (32). The electric module (10) is characterized by connection means (18, 22, 28) that are standard connection means (18,22,28).

## Description

The invention relates to an electric module to be used in particular in a motor vehicle according to the preamble of claim 1 and a motor vehicle with an electric module.

### Prior Art

Modular electronic components or electric modules are widely used in an automotive vehicle in order to group specific electronic functionalities. The grouped electronic components are encapsulated in a housing or casing, wherein the electrical connection is performed by connectors integrated in the housing or casing. In general each electric module or part of the module has specific type of connectors adapted to the function of the module. One type of electric module is an engine control unit, which is most commonly called the powertrain control module (PCM), and is a type of electronic communication and/or control unit (ECU) that controls a series of actuators on an internal combustion engine to ensure the optimum running. It does this by reading values from a multitude of sensors within the engine bay, interpreting the data using multidimensional performance maps (called Look-up tables), and adjusting the engine actuators accordingly.

Modern electronic communication and/or control units (ECUs) use a microprocessor which can process the inputs from the engine sensors in real time. An electronic control unit contains the hardware and software (firmware).

The hardware consists of electronic components on a printed circuit board (PCB), ceramic substrate or a thin laminate substrate. The main component on this circuit board is a microcontroller chip (central processing unit: CPU). The software is stored in the microcontroller or other chips on the PCB, typically in EPROMs or flash memory so the CPU can be re-programmed by uploading updated code or replacing chips. This is also referred to as an (electronic) Engine Management System (EMS). Sophisticated engine management systems receive inputs from other sources, and control other parts of the engine; for instance, some variable valve timing systems are electronically controlled, and turbocharger wastegates can also be managed. They also may communicate with transmission control units or directly interface electronically-controlled automatic transmissions, traction control systems, and the like. The Controller Area Network bus (CAN-bus) of the automotive network is often used to achieve communication between these devices.

In case the motor vehicle comprises an air conditioning system, the components of the air conditioning system like a heater based on a PTC (positive temperature coefficient) are grouped in a relay box or in the electronic communication unit (ECU) and are as well controlled by the electronic communication control unit (ECU).

The patent application EP 2 346 302 A1 discloses a heater and a method for manufacturing a heater, which may be used for an air conditioning of a vehicle. The heater comprises at least one PTC element with an electrical contact section and at least a power switch of a heater control circuit, wherein the at least one output of the power switch is hard fastened to the electrical contact section of the at least one PTC heating element by a fastening process based on heat or pressure.

The patent application EP 198 1052 A1 describes a control box with a dampened relay. The control box comprises a housing having connectors for electronic or electric components to be connected to the control box. The connectors are individually designed depending to the functionality of the component.

It is an object of the present invention to provide an electric module, which has an improved design and may be used in a modular set-up in a motor vehicle.

The object is solved by an electric module in particular for a motor vehicle comprising a housing in order to accommodate electric components and connection means for electrically connecting electric input and/or output and/or signal input and/or output of the electric components of the electric module to surrounding electric components and to the power network of the motor vehicle, wherein the housing comprises a top wall, a bottom wall, two side walls extending from the top wall to the bottom wall, wherein the connection means are standard connection means. The housing has the function of a black box which is designed to contain electronic components or electronic parts that fits inside the housing. The housing is preferably made of a plastic material. The housing has a top wall and an opposite the top wall arranged bottom wall, a right side wall and a left side wall, wherein the connection means are preferably arranged at the side walls and the bottom wall. Each connection means has preferably a standard type of pins or connectors which can be connected with pins or connectors of the electronic component to be connected to the related electronic part of the electric module. The connection means of the top wall, the bottom wall and the left and right wall can comprise preferably different numbers and arrangements of the pins in the connection means. The connection means can realize the connection to surrounding electric component and/or power supplies in an easy way. Thereby a fast and easy connection of different electric modules can be realized. A modularization can easily be realized by linking the electric modules together and/or by linking the electric module to an electric communication unit (ECU) or a power train board (PCB) and/or command navigation bus (CAN). The concept of standard connection means permits to develop only connector modules adapted to the requirements of signal or power connectors of the customer or the supplier of the connectors. Preferably the connection means are designed in a way that they fulfill the high level of requirements to prevent any failure on lifetime. The requirements of the electric modules used in the prior art are obsolete and have not any longer to be fulfilled and no restriction for modularization of different functionalities of an electric communication unit (ECU) or a relay box having a PTC (positive temperature coefficient) heater has to be taken into account.

In a preferred embodiment the connection means of the electric module comprises signal connection means, power connection means and charge connection means. The power connection means hereby preferably contains two pins, the signal connection means contains preferably three pins or five pins and there is preferably a third connection means foreseen for charging which contains five pins.

Preferably is the electric module equipped with power connection means that are designed to be used in a standard network having 12 V or in a power network of a hybrid, electrical vehicle.

In a further preferred embodiment of the electric module the signal connection means and the power connection means are arranged on opposite side walls of the housing. This arrangement is used as a standard design for every module. The counterpart of the surrounding device like power device or signal receiving module can easily be connected with this standard connection means. The packing of modules can thereby be optimized and space in a motor vehicle can be saved. No cables, especially long cables are needed anymore to connect the electric module with surrounding devices.

Preferably the charge connection means of the electric module are arranged on the bottom side of the housing. A simple plug in on top of another module or to the power train can be realized.

The electric module may comprise different electric submodules having specific functionalities. Thereby a grouping of certain functions can be realized in one electric module having standard connection means to connect the electric module to surrounding modules and power supplies.

A further embodiment of the electric module comprises connection means that are constructed to realize the connection to surrounding modules by one of the following connection methods: clinching, bonding, clipping, soldering, ultrasonic welding, cabling. The electric module can be an ECU (electronic communication unit) and/or a relay box. The ECU without connector is integrated in the housing and linked to each input and/or output by a standard connection means to different modules dedicated to command input, power input and power output.

The housing of the electric module can comprise a PTC (positive temperature coefficient) heater, in particular a three stages power heater. Thereby the air conditioning device can be built in a very compact way.

The object is solved as well by a motor vehicle comprising an electric module with electric components with the features according to the invention, in particular an electronic communication and/or control unit (ECU) and/or a relay box, wherein the electronic module comprises a housing containing electric components, in particular a heating device and a heating control circuit and connection means which are standardized. The new concept of the electric module with connection means following a standard systematic allows a direct integration of the electric controller, in particular the electronic control unit (ECU) on its charge independently to the connection requirements of a possible customer. The concept can be used for all kinds of networks, a 12 V standard network as well as a network in a hybrid, electric vehicle.

The invention is explained in detail using exemplary embodiments and with reference to the drawings, in which:
- Fig. 1: is a schematic top view of an electric module including an ECU and surrounding modules connectable to the ECU;
- Fig. 2: is a schematic front view of the electric module of Fig .1;
- Fig. 3: is a schematic side view of the module from Fig. 1 and Fig. 2.

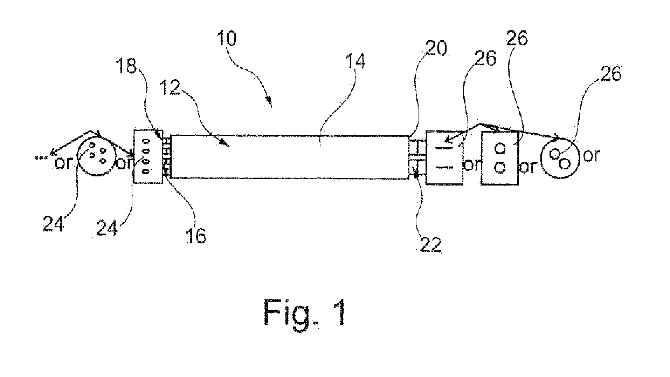

Figure 1 shows a schematic view of an electric module 10 having a housing 12 from which in figure 1 the top side 14 is depicted. At the side wall 16 starting from the top side 14 connection means 18 are arranged and on the side wall 20 extending from the top side 14 to a not shown bottom side connection means 22 are shown. The connection means 18 are designed to be connected with a four pin connector plug 24 typically used with for signal modules (not shown). The connection means 22 can be connected with the typical two pin containing plug 26 of a power supply device (not shown).

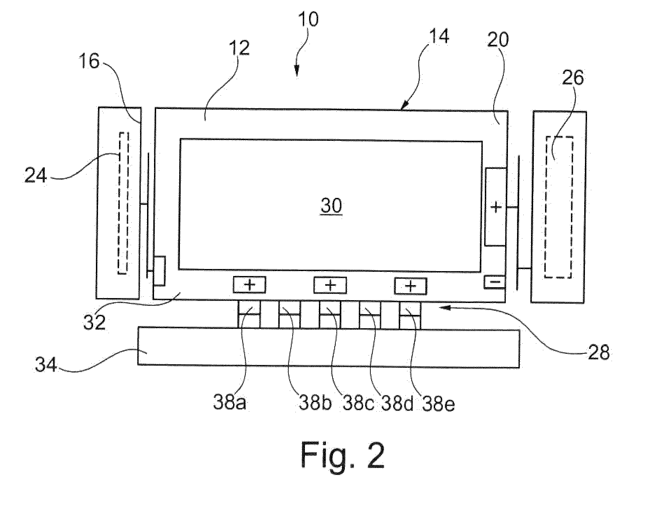

Figure 2 shows the electronic device 10 of figure 1 in a schematic front view. The electric module 10 comprises the housing 12 from which the front wall 27 is depicted. Inside the housing 12 may any electronic device 30 to be accommodated. The electronic device 30 can be an electric communication and/or control unit (ECU) and/or a relay box. In case the electric module 10 is used in an air conditioning device (not shown) mounted in a motor vehicle, the electronic device 30 can be a control device for the PTC heater. At a bottom wall 32 of the housing 12 a connection means 28 with five pins 38a, 38b, 38c, 38d, 38e is constructed which fits to a plug or connector of a charge device 34 (the PTC heater). The side wall 16 and the side wall 20 extending from the top wall 14 to the bottom wall 32 are shown. The plugs or connector 24 and 26 from surrounding devices are shown schematically.

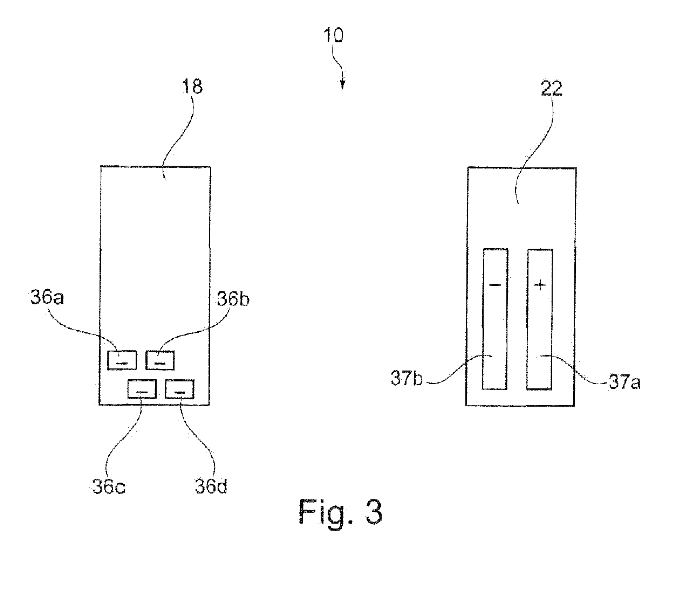

Figure 3 is a side view from the side wall 16 with connection means 18 and the side wall 20 with connection means 22. Connection means 18 comprises four pins 36a, 36b, 36c, 36d and connection means 22 comprises two connection parts 37a and 37b, which can be connected to a connector plug 26 of a power supply. Connection part 38a has to be connected to the positive output of the ECU or positive line of the power supply and connection part 38b has to be connected to the negative output of the ECU or negative line of the power supply.

The connection of the respective lines of the (electronic device 30 to be accommodated in the housing 12 of the electronic module 10 can be done by all known connecting methods like soldering, clinching, crimping, ultrasonic welding, clinching, cabling, bonding, clipping and the like.

The assembling of an electric module 10 is performed by providing the housing 12 and arranging the electronic device or the subcomponents inside the housing. The next step would be a connection step of the lines from the subcomponents or electronic device 30 to the connection means 18, 20, and 28 of the electric module 10. By this an electric module 10 which can be a module in an electric system of a motor vehicle can be mounted easily and a dense packaging can be achieved.

## Claims

1. Electric module in particular for a motor vehicle comprising a housing in order to accommodate an electric device (30) and connection means for electrically connecting electric input and/or output and/or signal input and/or output of the electric device (30) of the electric module to surrounding electric components and to the power network of the motor vehicle, wherein the housing (12) comprises a top wall (14), a bottom wall (32), a first side wall (16), a second side wall (20) opposite to the first side wall (16) and extending from the top wall (14) to the bottom wall (32), **characterized in that** the connection means (18, 22, 28) are standard connection means.

2. Electric module according to claim 1, **characterized in that** the connection means (18, 22, 28) comprises signal connection means (18), power connection means (22) and charge connection means (28).

3. Electric module according to any of the preceding claims, **characterized in that** the power connection means (22) is designed to be used in a standard network having 12 V and/or an electrical, hybrid network.

4. Electric module according to any of the preceding claims, **characterized in that** the signal connection means (18) and the power connection means (22) are arranged on opposite side walls (16, 20) of the housing (12).

5. Electric module according to any of the preceding claims, **characterized in that** the charge connection means (28) is arranged on the bottom wall (32) of the housing (12).

6. Electric module according to any of the preceding claims, **characterized in that** the electric module (10) comprises different electric submodules.

7. Electric module according to any of the preceding claims, **characterized in that** the connection means (18, 22, 28) are designed to realize the connection to surrounding modules by one of the following connection methods: clinching, bonding, clipping, soldering, ultrasonic welding, cabling.

8. Electric module electric component according to claim 1, **characterized in that** the electric module is an ECU (30) (electronic communication and/or control unit) and/or a relay box (30).

9. Electric module according to any of the preceding claims, **characterized in that** the housing (12) comprises a PTC heater (34), in particular a three stages power heater.

10. Motor vehicle comprising an electric module (10) according to any of the claims 1 to 9, in particular comprising an air conditioning device with a PTC heater and/or a PTC heater control device (30) according to claim 9.
